(19) Europäisches Patentamt
European Patent Office
Office européen des brevets

(11) **EP 2 369 023 A1**

(12) **EUROPEAN PATENT APPLICATION**

(43) Date of publication:
**28.09.2011 Bulletin 2011/39**

(51) Int Cl.:
*C22C 5/02* (2006.01)      *H01L 21/60* (2006.01)
*B23K 35/30* (2006.01)      *H01L 23/00* (2006.01)

(21) Application number: **11004085.4**

(22) Date of filing: **11.09.2008**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **06.11.2007 JP 2007289091**

(62) Document number(s) of the earlier application(s) in accordance with Art. 76 EPC:
**08846565.3 / 2 208 801**

(71) Applicant: **Tanaka Denshi Kogyo K.K.
Tokyo 100-6422 (JP)**

(72) Inventors:
• **Murai, Hiroshi**
  **Kanzaki-gun Saga 842-0031 (JP)**
• **Chiba, Jun**
  **Kanzaki-gun 842-0031 (JP)**

(74) Representative: **Stona, Daniel et al
Moinas & Savoye S.A.
42, rue Plantamour
1201 Genève (CH)**

Remarks:
This application was filed on 17-05-2011 as a divisional application to the application mentioned under INID code 62.

(54) **Bonding wire**

(57)   [Issues to be solved]
Second bonding failures caused attached oxide of additive elements on high purity Au bonding wire are to be dissolved.
  [Solution means]
  Au alloy bonding wires comprising:
0.01 - 1.2 wt % Pd,
5 - 100 wt ppm Mg,
5 - 20 wt ppm In,
5 - 20 wt ppm Al,
5 - 20 wt ppm Yb,

optionally 5 - 20 wt ppm Ca and/or at least more than one element among 5 - 20 wt ppm La, 5 - 20 wt ppm Lu, 5 - 100 wt ppm Sn, 5 - 100 wt ppm Sr,

the rest being Au having a purity greater than 99.99 wt %. Bonding wire, which contains these trace additive elements do not cause of disturbance by accumulated contamination, because of contamination, which formed at ball formation by micro discharge and at the first bonding to attached on tip of capillary, transferring to the wire at second bonding.

Fig. 1

EP 2 369 023 A1

**Description**

FIELD OF THE INVENTION

The present invention relates to bonding wire bonding with semiconductor devices and outer leads.

STATE OF THE ART

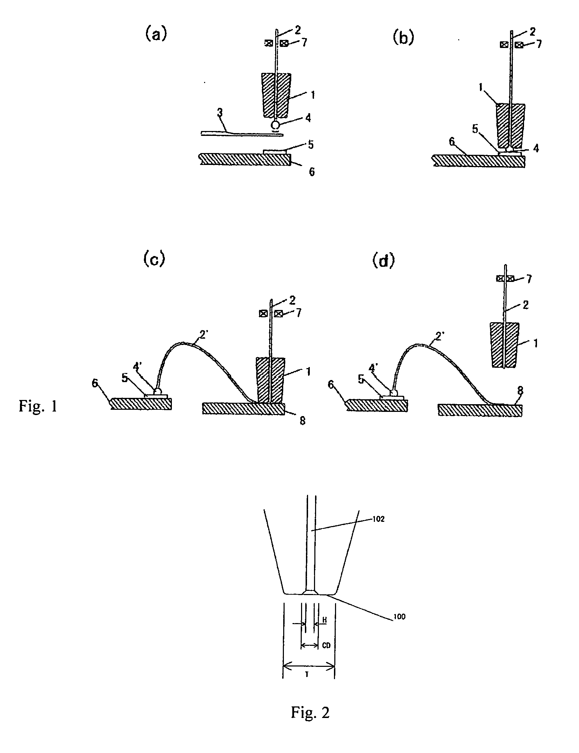

When connecting the outside wiring with an electrode of an IC chip, wire-bonding methods wired through a wire are known. Among these methods as a manner of bonding with Al electrodes of IC chip, thermo-compression and thermo-sonic bonding are occupied mainstream. Where as thermo-sonic bonding, ball-bonding method is used conventionally. Bonding method by ball bonding is explained using the figure illustrated in Reference Patent 1 (Japanese Patent Application No. 3657087) shown herein after. As shown in the Fig. 1(a), wire 2 is sent from a thin hole of tip of capillary through wire hole of capillary 1, electric torch 3 is set against the tip, discharging between wire 2, heating and melting the tip of wire 2, ball 4 is formed. Then as shown in the Fig. 1(b), capillary 1 is taken downward, said ball 4 is compressed bonded to Al electrode 5 on the IC chip 6 (the first bonding). Where, it is not illustrated here, ultrasonic vibration through capillary 1 is applied and since IC chip 6 is heated at heat block, said ball 4 compressed bonded becomes compressed ball 4'. Then as shown in the Fig. 1(c), capillary 1 is tracing a defined locus, it moves to above the outer circuit wire 8 of lead frame, and it goes down. Then, it is not illustrated here, ultrasonic vibration through capillary 1 is applied, since the outer circuit wire 8 is heated at heat block, side wall of wire 2 is thermal compressed and bonded (the second bonding). After bonding, as shown in the Fig. 1(d), clamper 7 goes upward with keeping clamped wire 2, wire 2 is cut at the state of slightly protrude (called as a tail) from a thin hole of tip of capillary, wiring is finished.

For wire bonding unit, cylindrical capillary 1 is made of high melting point material such as alumina, zirconia, ruby and sapphire, and there is a diamond coated tip of capillary of these high melting point material for longer life, the representative material is alumina. Capillary 1 has a wire lead hole 102 of its inside in order to insert metallic wire for bonding. For example, in the case of using around 25 μ meters diameter of metallic wire, the size of wire lead hole 102 is selected as the range from 33 μ meters to 40 μ meters. Outside of bottleneck of capillary 1 has around 10 degrees of taper angle because of bonding interval and shape and size of metallic wire after bonding. In this connection, the hole diameter H is 38 μ meters, the tip diameter is 152 μ meters, and the chamfer diameter CD is 64 μ meters.

Many various bonding wires had been developed so far. For example, it is well known that Au matrix alloy with partial additive of rare earth elements enhances tensile strength. And, as bonding wire which enhances tensile strength and shear strength, Au alloy thin wire comprising 1 - 10 wt ppm of Sr, 1 - 20 wt ppm of Be, 1 - 50 wt ppm and residual Au is known in Reference Patent 2 (Japanese Patent Application No. 3059314) here in after described. And 1 wt % Au alloy bonding wire improved bonding stability for long period use is also known. It is considered that these materials are completely alloyed in the pure Au matrix, and had not been researched the mischief on sublimation of trace additive elements so far.

In the bonding process, tip of the capillary 1 is heated to around 200 degrees in Celsius conventionally, and at initial ball forming process by arc discharge, surface temperature of tip of the capillary 1 rises instantly to higher than 1,000 degrees in Celsius. For this reason, as repeating bondings by high speed of ten and several times a second, hundreds of thousands of times under unmanned condition, tip 100 of the capillary 1 is contaminated by transferred materials from metallic wire nevertheless material of tip of capillary 1. After all, these contaminated materials are accumulated in homogeneously for a moment at tip 100 of the capillary 1. Sooner or later, the contaminated capillary 1 by these accumulated contaminations is suffered that necessary energy amount for bonding isn't impressed by disturbance of transformation of ultrasonic and force at the second bonding. In the case of capillary using conventional bonding wire material, by accumlated contaminations such as partial additives elements to tip 100, cutting off of the wire would not work well on the outer wiring 8 of lead frame after second bonding, or by once of percentage at hundreds of thousands of times this accumlated contamination is used to come off from tip 100 of capillary 1. A stop of bonding equipment occurs frequently by this second bonding defect, a suspended situation of the bonding process had often formed. More over, though bonding equipment didn't come to a stop, but considerable decrease of bonding strength at second bonding occurred.

[Reference Patent 1] Japanese Patent 3657087
[Reference Patent 2] Japanese Patent 3059314

DISCLOSURE OF INVENTION

ISSUES TO BE SOLVED BY THE PRESENT INVENTION

The present invention has been done to provide bonding wire, in view of the past's above-mentioned circumstances, which is same as conventional bonding wire at pull strength and superior roundness, more over repeating bondings by high speed of ten and several times a second, hundreds of thousands of times, accumlated contamination does not occure at tip of capillary and decrese of the second bonding strength.

ISSUES TO BE SOLVED BY THE PRESENT INVENTION

The inventors of the present invention had made every effort and investigated on Au alloy wires superior at strength of bonding wire. Consequently the effect that contamination does not accumulate at tip of capillary, though tip of capillary is contaminated by partial additive elements under the appropriate range of partial additives such as Mg, In, Al, and Yb to the purity of 99.995 wt % Au or the purity of 99.995 wt % Au - Pd alloy has been discovered and the present invention is accomplished.

Concretely, according to the present invention, Au alloy bonding wire comprising: 5 - 100 wt ppm Mg, 5 - 20 wt ppm In, 5 - 20 wt ppm Al, 5 - 20 wt ppm Yb, and residual Au is more than 99.995 wt % purity is provided.

And according to the present invention, Au alloy bonding wire comprising: 5 - 20 wt ppm Ca, and 5 - 100 wt ppm Mg, 5 - 20 wt ppm In, 5 - 20 wt ppm Al, 5 - 20 wt ppm Yb, and residual Au is more than 99.995 wt % purity is provided.

And according to the present invention, Au alloy bonding wire comprising: at least more than one element among 5 - 20 wt ppm La, 5 - 20 wt ppm Lu, 5 -100 wt ppm Sn, 5 - 100 wt ppm Sr, and others of 5 - 100 wt ppm Mg, 5 - 20 wt ppm In, 5 - 20 wt ppm Al, 5 - 20 wt ppm Yb, and residual Au is more than 99.995 wt % purity is provided.

And according to the present invention, Au alloy bonding wire comprising: at least more than one element among 5 - 20 wt ppm La, 5 - 20 wt ppm Lu, 5 - 100 wt ppm Sn, 5 - 100 wt ppm Sr, and others of 5 - 20 wt ppm Ca, 5 - 100 wt ppm Mg, 5 - 20 wt ppm In, 5 - 20 wt ppm Al, 5 - 20 wt ppm Yb, and residual Au is more than 99.995 wt % purity is provided.

On the other hand, according to the present invention, Au alloy bonding wire comprising: 0.01 - 1.2 wt % Pd, 5 - 100 wt ppm Mg, 5 - 20 wt ppm In, 5 - 20 wt ppm Al, 5 - 20 wt ppm Yb, and residual Au is more than 99.995 wt % purity is privided.

And according to the present invention, Au alloy bonding wire comprising: 0.01 - 1.2 wt % Pd, 5 - 20 wt ppm Ca, 5 - 100 wt ppm Mg, 5 - 20 wt ppm In, 5 - 20 wt ppm Al, 5 - 20 wt ppm Yb, and residual Au is more than 99.995 wt % purity is provided.

And according to the present invention, Au alloy bonding wire comprising: at least more than one element among 5 - 20 wt ppm La, 5 - 20 wt ppm Lu, 5 - 100 wt ppm Sn, 5 - 100 wt ppm Sr, and others of 0.01 - 1.2 wt % Pd, 5 - 100 wt ppm Mg, 5 - 20 wt ppm In, 5 - 20 wt ppm Al, 5 - 20 wt ppm Yb, and residual Au is more than 99.995 wt % purity is provided.

And according to the present invention, Au alloy bonding wire comprising: at least more than one element among 5 - 20 wt ppm La, 5 - 20 wt ppm Lu, 5 - 100 wt ppm Sn, 5 - 100 wt ppm Sr, and others of 0.01 - 1.2 wt % Pd, 5 - 20 wt ppm Ca, 5 - 100 wt ppm Mg, 5 - 20 wt ppm In, 5 - 20 wt ppm Al, 5 - 20 wt ppm Yb, and residual Au is more than 99.995 wt % purity is provided.

EFFECTS OF THE PRESENT INVENTION

Au alloy bonding wire of the present invention resolves obstacles of bonding defect and coming off by the contaminated substances, since at ball forming by micro discharge and at the first bonding, contaminated substances of oxide of trace additive elements are formed and sublimated, and it does not accumulate and transcript to objective bonding wire with ultrasonic and thermo-compressed operation at the second bonding.

BRIEF DESCRIPTION OF THE DRAWINGS

[Fig. 1] Explanatory schema of bonding method by ball bonding on the present invention

[Fig. 2] Cross section of tip of capillary using for bonding on the present invention

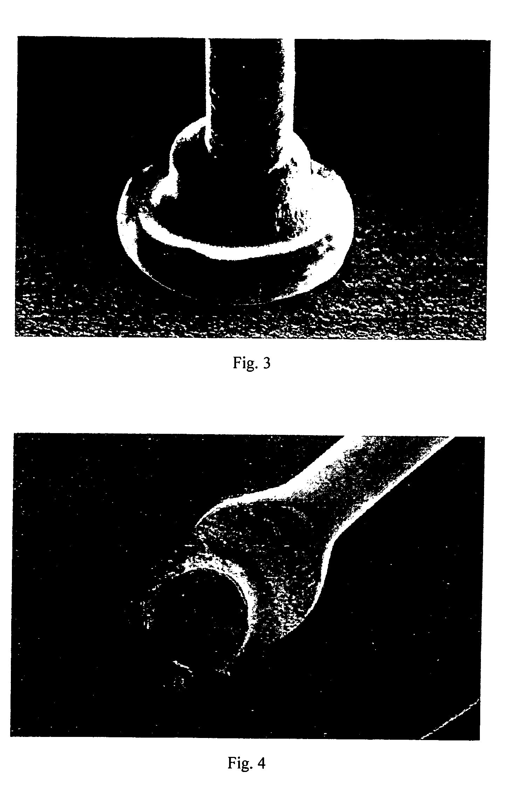

[Fig. 3] One example of shape of bond at the first bonding on the present invention

[Fig. 4] One example of shape of bond at the second bonding on the present invention

[Explanation of symbols]

1      Capillary

2      Wire

2'      Bonded wire

3      Electrode torch

4      Ball

4'      Compressed ball

5      IC Chip

6      Al electrode

7      Clamper

8      Outer wiring

100      Tip of capillary

102      Lead Hole for wire

DESCRIPTION OF THE MOST PREFERRED EMBODIMENT

In the present invention, there is few kind of trace additive elements, the range of components is narrow and definitive. Pure Au without any impurity is most superior for the second bondability of bonding wire, but all trace additive elements of the present invention do not disturb so much the superior second bondability of pure Au. Missing balance of ratio of trace additive elements of the present invention, shape of bonding portion compressed bonded is affected considerably at the second bonding.
By the way, in the case of Au alloy system, it is commercially advantageous, since it is available to display as high purity bonding wire more than 99.99 wt %, if the total amount of trace additive elements except Au and impurity elements is less than 100 wt ppm.

[Pd]

In the alloy system of the present invention, Pd is an element to contribute reliability of bonding for a long period at the first bonding section. The more additive of Pd increases reliability of bonding for a long period, but it becomes difficult to bond because of generating chip cracks and hardening of the initial ball under the more than 1.2 wt % Pd condition.

[Mg]

In the alloy system of the present invention, Mg is a crucial element for the better second bondability, and it is an effective element for roundness of compressed ball diameter after molten ball. On the other hand, Mg has no effect of enhancing strength of bonding wire, though Ca has it. In the alloy system of the present invention, it is necessary that amount of Mg should be more than 5 wt ppm. Because of less than this, there is no effect for second bondability. In the alloy system of the present invention, it is preferable that amount of Mg is more than 30 wt ppm in order to make second bondability of wire stable. On the other hand, in the alloy system of the present invention, in the case of amount of Mg is more than 100 wt ppm Mg, it has wrong effect for second bondability since oxide accumlates at capillary when initial ball forming. In the alloy system of the present invention, it is preferable that amount of Mg is less than 70 wt ppm Mg in order to make second bondability stable.

[In]

In the alloy system of the present invention, In is a crucial element for the better second bondability, and it is an effective element for roundness of compressed ball diameter after molten ball. On the other hand, In has no effect of enhancing strength of bonding wire, though Ca has it. In the alloy system of the present invention, it is preferable that amount of In is more than 5 wt ppm In in order to make second bondability of wire stable. Because of less than this, there is no effect for second bondability. On the other hand, in the alloy system of the present invention, in the case of amount of In is more than 20 wt ppm In, it has wrong effect for second bondability since oxide accumlates at capillary.

[A1]

In the alloy system of the present invention, Al is a crucial element for the better second bondability. On the other hand, Al has no effect of enhancing strength of bonding wire, though Ca has it. In the alloy system of the present invention, it is necessary that amount of Al should be more than 5 wt ppm Al. Because of less than this, there is no effect for second bondability. On the other hand, in the alloy system of the present invention, in the case of amount of Al is more than 20 wt ppm Al, it has wrong effect for second bondability since oxide accumlates at capillary.

[Yb]

In the alloy system of the present invention, Yb is a crucial element for the better second bondability, and moreover, it is an effective element for roundness of compressed ball diameter after molten ball. On the other hand, Yb has no effect of enhancing strength of bonding wire, though Ca has it. In the alloy system of the present invention, it is necessary that amount of Yb should be more than 5 wt ppm Yb. Because of less than this, there is no effect for second bondability. On the other hand, in the alloy system of the present invention, in the case of amount of Yb is more than 20 wt ppm Yb, it has wrong effect for second bondability since oxide accumlates at capillary.

[Ca]

In the alloy system of the present invention, Ca is the most effective element to improve tensile strength of wire. However, hence Ca is apt to accumulate oxide on the surface of chamfer at tip of capillary, in the alloy system of the present invention, Ca is an optional additive element, and additive amount of Ca is definitive. In the alloy system of the present invention, in the case of less than 5 wt ppm Ca, there is no effect for tensile strength, and in the case of more than 20 wt ppm Ca, it is apt to accumulate oxide on the surface of chamfer at tip of capillary, it has wrong effect for second bondability. Therefor additive amount of Ca is within the range of 5 - 20 wt ppm Ca.

[La]

In the alloy system of the present invention, La is an effective element to improve tensile strength of wire. Moreover, La is an effective element for second bondability. Furthemore, it is an effective element for roundness of compressed ball diameter after molten ball. However, hence La is apt to accumulate oxide at tip of capillary, in the alloy system of the present invention, La is an optional additive element, and additive amount of La is definitive. In the alloy system of the present invention, hence, in the case of less than 5 wt ppm La, there is no effect for tensile strength, and in the case of more than 20 wt ppm La, it accumulate oxide on the surface of chamfer at tip of capillary and it has wrong effect for second bondability. Therefor additive amount of La is within the range of 5 - 20 wt ppm La.

[Lu]

In the alloy system of the present invention, Lu is an effective element to improve tensile strength of wire. Moreover, Lu is an effective element for second bondability. However, hence Lu is apt to accumulate oxide on the surface at tip of capillary, in the alloy system of the present invention, Lu is an optional additive element, and additive amount of La is definitive. In the alloy system of the present invention, hence, in the case of less than 5 wt ppm Lu, there is no effect for tensile strength, and in the case of more than 20 wt ppm Lu, it accumulate oxide on the surface of chamfer at tip of capillary and it has wrong effect for second bondability. Therefor additive amount of Lu is within the range of 5 - 20 wt ppm Lu.

[Sn]

In the alloy system of the present invention, Sn is an effective element for second bondability. However, Sn is apt to accumulate oxide on tip surface of capillary, in the alloy system of present invention, Sn is an optional additive element and the additive amount of it is definitive. In the alloy system of the present invention, it is necessary that amount of Sn is more than 5 wt ppm Sn. Because of the case of less than 5 wt ppm Sn, there is no effect for second bondability. In the alloy system of the present invention, it is preferable that Sn is more than 30 wt ppm Sn in order to make second bondability of wire stable. On the other hand, in the alloy system of the present invention, in the case of more than 100 wt ppm Sn, such too much, oxide accumulates on the surface of tip at capillary, and it has wrong effect for second bondability. In the alloy system of the present invention, in order to make second bondability stable, it is preferable that additive amount of Sn is less than 70 wt ppm Sn.

[Sr]

In the alloy system of the present invention, Sr is an effective element for second bondability. Moreover, it is an effective element for roundness of compressed ball diameter after molten ball. However, Sr is apt to accumulate oxide on tip surface of capillary, in the alloy system of present invention, Sr is an optional additive element and the additive amount of it is definitive. In the alloy system of the present invention, it is necessary that amount of Sr is more than 5 wt ppm Sr. Because of the case of less than 5 wt ppm Sr, there is no effect for second bondability. In the alloy system of the present invention, it is preferable that Sr is more than 30 wt ppm Sr in order to make second bondability of wire stable. On the other hand, in the alloy system of the present invention, in the case of more than 100 wt ppm Sr, such too much, oxide accumulates on the surface of tip at capillary, and it has wrong effect for second bondability. In the alloy system of the present invention, in order to make second bondability stable, it is preferable that additive amount of Sr is less than 70 wt ppm Sr.

On bonding wire of the present invention, second bondability, tensile strength and roundness of compressed ball diameter after molten ball have been measured by the following manner.

(1) Second bondability

Second bondability is defined as easiness to bond to lead frame deforming the wire by applying thermo-load-ultrasonic on stitch bonding, while the bonding wire is pressed to Ag plated 42 alloy on lead frame. On second bondability, during 500 thousand repeated bonding test, it has been measured as number of un-bonded.

(2) Tesile strength

It was measured by using conventional tensile testing machine at 4 % elongation. Measurement was done at room temperature, at 100 mm gauge length, and at 10 mm/min speed, and was calculated from acquired value of load and elongation as fracture. By the way, elongation was calculated by using next equation from elongation as fracture.

[Equation 1]

$$\text{Elongation} = \frac{\text{Elongated length as fracture (mm)}}{100 \ (\text{mm})} \times 100 \ (\%)$$

(3) Compressed diameter after molten ball

Evaluation of compressed diameter after molten ball was done by followng manner. It was ball bonded at Al electrode (thickness of Al: around $1 \times 10^{-6}$ m) on Si chip, then it was wired to Ag plated 42 alloy on lead frame by stitch bonding. Then, it was evalutated under condition of span is $3 \times 10^{-3}$ m, to optionally selected 50 bonded wires from 200 bonded wires. After measuring compressed ball diameters of applied direction of ultrasonic wave and paralell direction and virtical direction, it was shown as in "Good" for the ratio range of 0.95 - 1.05, as in "Fair" for the ratio range of 0.90 - 1.00 (where except 0.95 - 1.05), and as in "Worse" for other range.

(4) Manufacturing Method of Au alloy wire

Preferable manufacturing method of Au alloy wire on the present invention is explained. It is casted into ingot after melting in the vacuum furnace adding prescribed amount of elements into high purity Au. It is applied cold metal forming using ditch roll and drawing mill to said ingot, and intermediate annealing, after getting thin wire which diameter is 25 x 10$^{-6}$ meters by final drawing, it is conditioned at 4 % elongation by final annealing.

(5) Usage

Bonding wire of the present invention is favorable to the method which bonds IC chip to lead frame. Where, said ball bonding means when wiring with wire and electrode of IC chip, especially Al electrode, and outer lead, and other electrode, it is formed molten ball, but at second bonding, without ball forming, side of wire is compressed. Corresponding to needs it is impressed ultrasonic wave, and it is heated electrode.

EFFECTS OF THE PRESENT INNVENTION

[Effects]

When using Au alloy bonding wire and/or Pd-Au alloy wire on the present invention, after several hundreds thousands bonding at such high speed the reason why second bondability is not deteriorated is not exactly known, but it is considered as following manner. Namely, oxide of trace additive elements is formed and attached at tip of capillary when ball forming by arc discharge and at first bonding, it is considered that attached oxide is printed to wire side by each second bonding. Therefore, though there is thin layer of oxide at tip of capillary, it does not form thick contamination accumulated. It is considered that such attached oxide is transferred to wire side during second bonding before making thick contamination accumulated at tip of capillary. Consequently, it is considered that Au alloy bonding wire and/or Pd-Au alloy wire on the present invention has superior effects for second bonding. Bonding wire of the present invention has properly superior effect for pull strength and roundness.

DESCRIPTION OF THE MOST PREFERRED EMBODIMENT

[Examples]

It is explained the most prefferred embodiment and compared examples shown in Table 1-1, Table 1-2, Table 1-3 and Table 2.

(Example 1)

After adding prescribed amount of additive elements to high purity Au of purity of 99.999 wt % and/or high purity Au alloyed prescribed amount of Pd were melted in the vacum furnace, then Au alloy ingots were gotten, which components shown in Table 1-1 and Table 1-2 and Table 1-3 after casting. These ingots were roll formed by ditch roll, and were cold worked by using a drowing mill and intermediated annealing, finally finished thin wire was gotten, which diameter is 25 μ meters by final drawing, was conditioned at 4 % elongation by final annealing.
Table 1-1

| No. | Au | Pd wt % | Additive element (wt ppm) | | | | | | | | |
|-----|----|---------|------|-----|-----|-----|-----|-----|-----|-----|-----|
| | | | Mg | In | Al | Yb | Ca | La | Lu | Sn | Sr |
| 1 | residual | | 49 | 9 | 10 | 14 | | | | | |
| 2 | residual | | 34 | 16 | 13 | 8 | | | | | |
| 3 | residual | | 58 | 11 | 17 | 12 | | | | | |
| 4 | residual | | 16 | 18 | 6 | 9 | | | | | |
| 5 | residual | | 90 | 7 | 9 | 17 | | | | | |
| 6 | residual | | 64 | 13 | 18 | 15 | | | | | |

(continued)

| No. | Au | Pd wt % | Additive element (wt ppm) | | | | | | | | |
|-----|-----|---------|-----|-----|-----|-----|-----|-----|-----|-----|-----|
| | | | Mg | In | Al | Yb | Ca | La | Lu | Sn | Sr |
| 7 | residual | | 46 | 13 | 7 | 11 | 6 | | | | |
| 8 | residual | | 33 | 14 | 17 | 9 | 17 | | | | |
| 9 | residual | | 40 | 6 | 12 | 10 | 13 | | | | |
| 10 | residual | | 44 | 8 | 7 | 13 | | 18 | | | |
| 11 | residual | | 31 | 12 | 14 | 7 | | | 14 | | |
| 12 | residual | | 50 | 17 | 8 | 14 | | | | 68 | |
| 13 | residual | | 68 | 10 | 19 | 19 | | | | 10 | |
| 14 | residual | | 25 | 14 | 9 | 12 | | 15 | | 92 | |
| 15 | residual | | 43 | 18 | 15 | 6 | | 13 | 17 | | |
| 16 | residual | | 62 | 15 | 16 | 18 | | | 12 | 44 | |
| 17 | residual | | 52 | 10 | 11 | 13 | | 8 | 6 | 52 | |
| 18 | residual | | 37 | 16 | 8 | 6 | | | | | 37 |
| 19 | residual | | 55 | 12 | 13 | 16 | | | | | 68 |
| 20 | residual | | 66 | 8 | 19 | 8 | | | | | 55 |
| 21 | residual | | 84 | 6 | 16 | 18 | | | | | 10 |
| 22 | residual | | 35 | 17 | 18 | 19 | | 15 | | | 43 |
| 23 | residual | | 60 | 9 | 6 | 14 | | | 13 | | 58 |
| 24 | residual | | 42 | 13 | 10 | 11 | | | | 60 | 34 |
| 25 | residual | | 54 | 9 | 8 | 15 | | 11 | 8 | | 64 |
| 26 | residual | | 53 | 15 | 11 | 17 | | 7 | 9 | 48 | 49 |
| 27 | residual | | 38 | 19 | 15 | 16 | 11 | | | | 46 |
| 28 | residual | | 61 | 11 | 11 | 10 | 8 | | | | 90 |
| 29 | residual | | 45 | 11 | 14 | 12 | 10 | 16 | | | |
| 30 | residual | | 57 | 8 | 12 | 17 | 18 | | 15 | | |
| 31 | residual | | 39 | 12 | 10 | 15 | 14 | | | 40 | |
| 32 | residual | | 47 | 7 | 7 | 16 | 16 | 14 | 10 | | |
| 33 | residual | | 56 | 14 | 12 | 7 | 9 | 9 | | 56 | |
| 34 | residual | | 41 | 10 | 9 | 13 | 15 | 10 | 11 | | 52 |
| 35 | residual | | 51 | 19 | 13 | 11 | 12 | 9 | 18 | 64 | 40 |
| 36 | residual | 1.0 | 32 | 11 | 9 | 14 | | | | | |

Table 1-2

| No. | Au | Pd wt % | Additive element (wt ppm) | | | | | | | | |
|-----|-----|---------|-----|-----|-----|-----|-----|-----|-----|-----|-----|
| | | | Mg | In | Al | Yb | Ca | La | Lu | Sn | Sr |
| 37 | residual | 1.0 | 59 | 18 | 10 | 8 | | | | | |
| 38 | residual | 1.0 | 48 | 7 | 13 | 12 | | | | | |

(continued)

| No. | Au | Pd wt % | Additive element (wt ppm) | | | | | | | | |
|-----|-----|---------|-----|-----|-----|-----|-----|-----|-----|-----|-----|
| | | | Mg | In | Al | Yb | Ca | La | Lu | Sn | Sr |
| 39 | residual | 0.5 | 10 | 13 | 17 | 15 | | | | | |
| 40 | residual | 1.0 | 78 | 16 | 19 | 6 | | | | | |
| 41 | residual | 1.0 | 36 | 6 | 9 | 16 | | | | | |
| 42 | residual | 1.0 | 51 | 14 | 18 | 8 | | | | | 58 |
| 43 | residual | 1.0 | 49 | 6 | 15 | 18 | | | | | 31 |
| 44 | residual | 1.0 | 46 | 13 | 13 | 11 | | | | | 45 |
| 45 | residual | 0.1 | 19 | 14 | 6 | 9 | | | | | 22 |
| 46 | residual | 1.0 | 53 | 12 | 16 | 10 | 19 | | | | |
| 47 | residual | 1.0 | 47 | 19 | 7 | 16 | 7 | | | | |
| 48 | residual | 1.0 | 54 | 11 | 17 | 10 | 10 | | | | |
| 49 | residual | 1.0 | 46 | 15 | 8 | 13 | 13 | | | | 61 |
| 50 | residual | 1.0 | 55 | 18 | 11 | 7 | 15 | | | | 84 |
| 51 | residual | 0.5 | 44 | 17 | 7 | 14 | | 17 | | | |
| 52 | residual | 1.0 | 34 | 10 | 14 | 19 | | | 13 | | |
| 53 | residual | 1.0 | 59 | 8 | 8 | 12 | | | | 63 | |
| 54 | residual | 1.0 | 45 | 12 | 19 | 6 | | 11 | | 80 | |
| 55 | residual | 0.1 | 96 | 8 | 15 | 17 | | | | 22 | |
| 56 | residual | 1.0 | 33 | 10 | 7 | 18 | | 9 | 8 | | |
| 57 | residual | 1.0 | 68 | 17 | 11 | 13 | | | 10 | 41 | |
| 58 | residual | 1.0 | 63 | 9 | 18 | 19 | | 16 | 17 | 53 | |
| 59 | residual | 1.0 | 31 | 13 | 6 | 14 | | 10 | | | 46 |
| 60 | residual | 1.0 | 62 | 9 | 10 | 11 | | | 19 | | 35 |
| 61 | residual | 1.0 | 32 | 8 | 8 | 15 | | | | 58 | 67 |
| 62 | residual | 1.0 | 66 | 11 | 11 | 9 | | 8 | 12 | | 47 |
| 63 | residual | 0.5 | 38 | 15 | 14 | 17 | | 14 | 11 | 49 | 59 |
| 64 | residual | 1.0 | 59 | 12 | 12 | 12 | 8 | 16 | 16 | | |
| 65 | residual | 1.0 | 34 | 1 7 | 10 | 17 | 12 | | 9 | | |
| 66 | residual | 1.0 | 61 | 14 | 16 | 15 | 14 | | | 37 | |
| 67 | residual | 0.5 | 47 | 10 | 12 | 16 | 17 | 12 | 19 | | |
| 68 | residual | 1.0 | 31 | 19 | 9 | 7 | 16 | 19 | | 53 | |
| 69 | residual | 1.0 | 48 | 9 | 13 | 13 | 9 | 6 | 7 | | 33 |
| 70 | residual | 1.0 | 50 | 10 | 12 | 11 | 14 | 17 | 14 | 32 | 63 |

Table 1-3

| No. | Au | Pd wt % | Additive element (wt ppm) | | | | | | | | |
|---|---|---|---|---|---|---|---|---|---|---|---|
| | | | Mg | In | Al | Yb | Ca | La | Lu | Sn | Sr |
| Conventional 1 | residual | | | 20 | | | 2 | 2 | | | 5 |
| Conventional 2 | residual | 1.0 | | | | | | | | | |
| Comparative 1 | residual | | 3 | 3 | 3 | 3 | | | | | |
| Comparative 2 | residual | 1.0 | 3 | 1 | 20 | 16 | 25 | | 2 | 10 5 | 10 5 |
| Comparative 3 | residual | 0.5 | 110 | 22 | 22 | 22 | | | | | |

| (Note) "Convetional 1" in the Table 1-3 corresponds to the Example 29 in Reference Patent 2, and "Convetional 2" and "Comparative 1 - 3" are comparative examples, which components are out of the range of the present invention. Where, Conventional 1 contains 10 wt ppm Be and 2 wt ppm Sc. |
|---|

(500 thousands cycle test)

These Au alloy wires were examined by 500 thousands cycle test, continuously were ball bonded with ultrasonic wave onto Al electrods on IC chip and onto outer wiring, using ball bonding equipment, which brand name is Max$\mu$m Plus from K&S Corporation. Where, it was done under the condition of ball bonding load is 0.2 N, time of ball bonding is 10 ms, ball bonding power is 0.30 w at ball bonding of IC chip side, and at second bonding of outer wiring, it was done under condition of ball bonding load is 0.3 N, time of ball bonding is 10 ms, ball bonding power 0.40 w. From this test, it was counted number of stop of ball bonding equipment by failure of second bonding. The result is shown in Table 2.
(3) Roundness of compressed diameter after molten ball Evaluation of roundness of compressed diameter after molten ball was done from 700 wires by making samples mentioned manner herein before, by the way different from 500 thousand cycle test. Namely, masuring compressed diameters of parallel direction of ultarasonic applied and virtical direction of it, comparing with each data, it was shown as in "Good" for the ratio range 0.95 - 1.05, as in "Fair" for the ratio range 0.90 - 1.00 (where except 0.95 - 1.05), and as in "Worse" for other range. The result is shown in Table 2.

Table 2 Results of 500 thousands cycle test

| No. | Number of failure of 2nd Bonding | Roundness | No. | Number of failure of 2nd Bonding | Roundness |
|---|---|---|---|---|---|
| 1 | 2 | Fair | 39 | 3 | Good |
| 2 | 2 | Fair | 40 | 2 | Fair |
| 3 | 2 | Fair | 41 | 2 | Fair |
| 4 | 3 | Fair | 42 | 1 | Good |
| 5 | 1 | Fair | 43 | 1 | Good |
| 6 | 2 | Fair | 44 | 1 | Good |
| 7 | 2 | Fair | 45 | 2 | Good |
| 8 | 3 | Fair | 46 | 2 | Fair |
| 9 | 2 | Fair | 47 | 2 | Fair |
| 10 | 1 | Fair | 48 | 2 | Fair |
| 11 | 2 | Good | 49 | 1 | Good |

(continued)

| No. | Number of failure of 2nd Bonding | Roundness | No. | Number of failure of 2nd Bonding | Roundness |
|---|---|---|---|---|---|
| 12 | 1 | Fair | 50 | 0 | Good |
| 13 | 2 | Fair | 51 | 1 | Fair |
| 14 | 0 | Fair | 52 | 2 | Good |
| 15 | 1 | Good | 53 | 1 | Fair |
| 16 | 1 | Fair | 54 | 1 | Fair |
| 17 | 0 | Fair | 55 | 1 | Fair |
| 18 | 2 | Good | 56 | 1 | Good |
| 19 | 0 | Good | 57 | 1 | Fair |
| 20 | 1 | Good | 58 | 0 | Fair |
| 21 | 1 | Good | 59 | 1 | Good |
| 22 | 0 | Good | 60 | 1 | Good |
| 23 | 1 | Good | 61 | 0 | Good |
| 24 | 0 | Good | 62 | 0 | Good |
| 25 | 0 | Good | 63 | 0 | Good |
| 26 | 0 | Good | 64 | 1 | Fair |
| 27 | 1 | Good | 65 | 2 | Fair |
| 28 | 0 | Good | 66 | 2 | Fair |
| 29 | 1 | Good | 67 | 1 | Good |
| 30 | 2 | Fair | 68 | 0 | Fair |
| 31 | 1 | Fair | 69 | 1 | Good |
| 32 | 1 | Good | 70 | 0 | Good |
| 33 | 1 | Fair | | | |
| 34 | 0 | Good | Conventional 1 | 4 | Good |
| 35 | 0 | Good | Conventional 2 | 4 | Fair |
| 36 | 2 | Fair | Comparative 1 | 4 | Fair |
| 37 | 2 | Fair | Comparative 2 | 4 | Good |
| 38 | 2 | Fair | Comparative 3 | 5 | Fair |

From the results shown herein before, in Table 1-1, Table 1-2, Table 1-3 and Table 2, Example 1 - 6 have the same range of component described in the claim 1, and the number of failure of second bonding are 1 - 3 times in 500 thousand cycles, and the roundness are "Fair". From these results, it is known that effect of additive elements such as Mg, In, Al and Yb is greate. More over, in same manner, Example 7 - 9 have the same range of component described in the claim 2, decrease number of failure of second bonding and improve roundness by adding Ca as same as said before. In the case of Example 10 - 21, in same manner herein after, have the same range of component described in the claim 3, it is recognized that these examples decrease number of failure of second bonding and also improve roundeness by the effect of adding La, Lu, Sn and Sr to the component of Example 1 - 6. Example 22 -35 have the same range of component described in the claim 4, these show the effect of adding Ca. Example 36 - 41 have the same range of component described in the claim 5, Example 42 - 50 have the same range of component described in the claim 6, each example is added 0.1 - 1.0 wt % Pd to the component of claim 1 and/or claim 2, and they show the same effect. Example 51 - 58 coresspond to the same range of component described in the claim 7, and Example 59 - 70 coresspond to the same range of component described in the claim 8, these are shown the effect of adding Pd to the component of claim 3 and claim 4 described herein before. Contrary to these examples, conventional 1 and conventional 2 are lack of the range of additive elements, though roundness were good, but occurred 4 times of second bonding failures for the 500 thousands bonding cycles. Comparative 1 - 3 show the case of out of the range on the present invention, which mean less and over. In these cases, roundness is good as same as described before, but it shows tendency of deterioration such as 4 - 5 times of second bonding failures, it is shown that it is important to keep the range of component.

As described herein before, each bonding wire of the present invention considerably decreases bonding failures at 500 thousands bonding cycle test.

POSSIBILITY FOR INDUSTRIAL USE

According to bonding wire of the present invention, Au alloy of prescribed additive elements of Mg-In-Al-Yb and/or Au alloy with Pd, more over, what added Ca to these alloys, and what added trace additive elements of La, Lu, Sn and Sr to these alloys, are superior at second bondability, more over, have superior effect of pull strength and second bondability as same as conventional bonding wire so far, it is effective to improve reliability of semi conductor devices.

**Claims**

1.  Au alloy bonding wire comprising:

    0.01 - 1.2 wt % Pd,
    5 - 100 wt ppm Mg,
    5 - 20 wt ppm In,
    5 - 20 wt ppm Al,
    5 - 20 wt ppm Yb,
    optionally 5 - 20 wt ppm Ca and/or at least more than one element among 5 - 20 wt ppm La, 5 - 20 wt ppm Lu,
    5 - 100 wt ppm Sn, 5 - 100 wt ppm Sr,

    the rest being Au having a purity greater than 99.99 wt %.

2.  Au alloy bonding wire according to claim 1 comprising:

    0.01 - 1.2 wt % Pd,
    5 - 100 wt ppm Mg,
    5 - 20 wt ppm In,
    5 - 20 wt ppm Al,
    5 - 20 wt ppm Yb,
    5 - 20 wt ppm Ca,

    the rest being Au having a purity greater than 99.99 wt %.

3.  Au alloy bonding wire according to claim 1 comprising:

    0.01 - 1.2 wt % Pd,
    5 - 100 wt ppm Mg,
    5 - 20 wt ppm In,
    5 - 20 wt ppm Al,
    5 - 20 wt ppm Yb,
    at least more than one element among 5 - 20 wt ppm La,
    5 - 20 wt ppm Lu, 5 - 100 wt ppm Sn, 5 - 100 wt ppm Sr,

    the rest being Au having a purity greater than 99.99 wt %.

4.  Au alloy bonding wire according to claim 1 comprising:

    0.01 - 1.2 wt % Pd,
    5 - 100 wt ppm Mg,
    5 - 20 wt ppm In,
    5 - 20 wt ppm Al,

5 - 20 wt ppm Yb,
5 - 20 wt ppm Ca,
at least more than one element among 5 - 20 wt ppm La,
5 - 20 wt ppm Lu, 5 - 100 wt ppm Sn, 5 - 100 wt ppm Sr,

the rest being Au having a purity greater than 99.99 wt %.

(a)  (b)

(c)  (d)

Fig. 1

Fig. 2

Fig. 3

Fig. 4

Europäisches
Patentamt

European
Patent Office

Office européen
des brevets

# EUROPEAN SEARCH REPORT

Application Number

EP 11 00 4085

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2000 040710 A (SUMITOMO METAL MINING CO) 8 February 2000 (2000-02-08) * the whole document * | 1-4 | INV. C22C5/02 H01L21/60 B23K35/30 H01L23/00 |
| A | JP 11 186314 A (SUMITOMO METAL MINING CO) 9 July 1999 (1999-07-09) * the whole document * | 1-4 | |
| A | JP 63 145729 A (NITTETSU MICRO METAL KK) 17 June 1988 (1988-06-17) * the whole document * | 1-4 | |
| A | JP 10 303235 A (TANAKA ELECTRONICS IND) 13 November 1998 (1998-11-13) * the whole document * | 1-4 | |
| A | JP 10 303237 A (TANAKA ELECTRONICS IND) 13 November 1998 (1998-11-13) * the whole document * | 1-4 | |
| A | JP 8 291348 A (NIPPON STEEL CORP) 5 November 1996 (1996-11-05) * the whole document * | 1-4 | TECHNICAL FIELDS SEARCHED (IPC) C22C B23K H01L |
| A | JP 11 045902 A (SUMITOMO METAL MINING CO) 16 February 1999 (1999-02-16) * the whole document * | 1-4 | |
| A | JP 8 127828 A (TANAKA ELECTRONICS IND) 21 May 1996 (1996-05-21) * the whole document * | 1-4 | |
| A | EP 1 811 555 A1 (TANAKA ELECTRONICS IND [JP]) 25 July 2007 (2007-07-25) * claims 1-7 * | 1-4 | |

The present search report has been drawn up for all claims

| Place of search | Date of completion of the search | Examiner |
|---|---|---|
| The Hague | 18 July 2011 | Vlassi, Eleni |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 11 00 4085

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2011

| Patent document cited in search report | | Publication date | Patent family member(s) | | | Publication date |
|---|---|---|---|---|---|---|
| JP 2000040710 | A | 08-02-2000 | NONE | | | |
| JP 11186314 | A | 09-07-1999 | NONE | | | |
| JP 63145729 | A | 17-06-1988 | JP | 1780630 | C | 13-08-1993 |
| | | | JP | 4071975 | B | 17-11-1992 |
| JP 10303235 | A | 13-11-1998 | JP | 3669809 | B2 | 13-07-2005 |
| JP 10303237 | A | 13-11-1998 | JP | 3669811 | B2 | 13-07-2005 |
| JP 8291348 | A | 05-11-1996 | JP | 3579493 | B2 | 20-10-2004 |
| JP 11045902 | A | 16-02-1999 | NONE | | | |
| JP 8127828 | A | 21-05-1996 | NONE | | | |
| EP 1811555 | A1 | 25-07-2007 | CN | 101040372 | A | 19-09-2007 |
| | | | WO | 2006035803 | A1 | 06-04-2006 |
| | | | JP | 3969671 | B2 | 05-09-2007 |
| | | | KR | 20070058681 | A | 08-06-2007 |
| | | | US | 2008050267 | A1 | 28-02-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3657087 B

- JP 3059314 B